(19) Europäisches Patentamt / European Patent Office / Office européen des brevets

(11) EP 2 886 669 A1

(12) EUROPEAN PATENT APPLICATION

(43) Date of publication:
24.06.2015 Bulletin 2015/26

(51) Int Cl.:
$C22C\ 1/04^{(2006.01)}$     $C22C\ 38/00^{(2006.01)}$
$H01L\ 35/20^{(2006.01)}$

(21) Application number: 14193879.5

(22) Date of filing: 19.11.2014

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(30) Priority: 19.11.2013 JP 2013239155
10.09.2014 JP 2014184235

(71) Applicant: HITACHI METALS, LTD.
Minato-ku,
Tokyo 105-8614 (JP)

(72) Inventors:
• Nishide, Akinori
Tokyo, 100-8280 (JP)

• Hayakawa, Jyun
Tokyo, 100-8280 (JP)
• Yabuchi, Shin
Tokyo, 100-8280 (JP)
• Kurosaki, Yosuke
Tokyo, 100-8280 (JP)
• Fukatani, Naoto
Tokyo, 100-8280 (JP)

(74) Representative: MERH-IP
Matias Erny Reichl Hoffmann
Paul-Heyse-Strasse 29
80336 München (DE)

(54) **Thermoelectric conversion material and thermoelectric conversion module using the same**

(57) The present invention provides a thermoelectric conversion material that is a material comprising elements less poisonous than Te and has a Seebeck coefficient comparable to BiTe. The present invention is a full-Heusler alloy that is represented by the composition formula $Fe_{2+\sigma}Ti_{1+y}Si_{1+z}$ and has $\sigma$, y, and z allowing the material to fall within the region surrounded by (Fe, Ti, Si) = (50, 37, 13), (50, 14, 36), (45, 30, 25), (39.5, 25, 35.5), (54, 21, 25), and (55.5, 25, 19.5) by at% in an Fe-Ti-Si ternary alloy phase diagram.

FIG. 1B

EP 2 886 669 A1

**Description**

FIELD OF THE INVENTION

The present invention relates to a thermoelectric conversion material and a thermoelectric conversion module using the thermoelectric conversion material.

BACKGROUND OF THE INVENTION

In recent years, international concern on the reduction of $CO_2$ that is thought to be a substance responsible for the global warming phenomenon increases and technological innovation for transferring from resource energy emitting a large volume of $CO_2$ to next-generation energy including natural energy and the reutilization of thermal energy advances. As candidates for next-generation energy technologies, a technology of using natural energy such as sunlight and wind power and a technology of reutilizing a lost part of primary energy such as heat emitted by the use of resource energy and vibration are considered.

Whereas conventional resource energy is centralized energy supplied mainly by large-scale electric generating facilities, a feature of the next-generation energy is that both natural energy and reusable energy take the form of being unevenly distributed. In energy utilization today, the energy that is not utilized but exhausted accounts for as large as about 60% of primary energy and is discharged in the form of exhaust heat. Consequently, the improvement of a technology of increasing the proportion of next-generation type energy in primary energy and simultaneously reutilizing energy, in particular converting exhaust heat energy into electric power, is requested.

When the utilization of exhaust heat energy is considered, since exhaust heat is generated at various situations, an electric generating system having a high versatility in installation mode is required. As a dominant candidate technology, a thermoelectric conversion technology is named.

The core of the thermoelectric conversion technology is a thermoelectric conversion module. The thermoelectric conversion module is arranged close to a heat source and generates electricity by generating temperature difference in the module. The thermoelectric conversion module takes a structure of alternately arraying: an n-type thermoelectric conversion material of generating electromotive force from a high temperature side to a low temperature side along a temperature gradient; and a p-type thermoelectric conversion material generating electromotive force in the inverse direction to the n-type thermoelectric conversion material.

The maximum output P of a thermoelectric conversion module is decided by the product of a heat flow rate Q flowing in the module and a conversion efficiency $\eta$ of a thermoelectric conversion material. The heat flow rate Q depends on a module structure suitable for a thermoelectric conversion material. Further, the conversion efficiency $\eta$ depends on a non-dimensional variable ZT that is decided by the Seebeck coefficient S, the electric resistivity $\rho$, and the heat conductivity $\kappa$ of a material. Consequently, it is necessary to improve the physical property value of a thermoelectric conversion material in order to improve the conversion efficiency.

To cope with the problem, research on many thermoelectric conversion materials has heretofore been worked on. As a thermoelectric conversion material already practically used, there is a BiTe alloy. Although the material has a high conversion efficiency, both Bi and Te are expensive, Te is highly poisonous, and hence mass production, cost reduction, and environmental load reduction are hardly attained. Consequently, a highly-efficient thermoelectric conversion material substituting for a BiTe alloy is desired. International Publications WO 2003/019681 and WO 2013/093967 describe a thermoelectric conversion material that adopts a material having a Heusler alloy type crystal structure.

SUMMARY OF THE INVENTION

A conventional Heusler alloy is less poisonous than Te but has not necessarily exhibited characteristics comparable to BiTe.

An object of the present invention is to provide: a thermoelectric conversion material that is a material comprising elements less poisonous than Te and has a Seebeck coefficient comparable to BiTe; and a thermoelectric conversion module having a thermoelectric conversion efficiency comparable to the case of using BiTe by using the thermoelectric conversion material.

An embodiment for attaining the object of the present invention is a thermoelectric conversion material that: is a full-Heusler alloy; is represented by the composition formula $Fe_{2+\sigma}Ti_{1+y}Si_{1+z}$; and has $\sigma$, y, and z allowing the material to fall within the region surrounded by (Fe, Ti, Si) = (50, 37, 13), (50, 14, 36), (45, 30, 25), (39.5, 25, 35.5), (54, 21, 25), and (55.5, 25, 19.5) {excluding (50, 25, 25)} by at% in an Fe-Ti-Si ternary alloy phase diagram.

Further, the present invention is a thermoelectric conversion material that: is a full-Heusler alloy; is represented by the composition formula $Fe_{2+\sigma}Ti_{1+y}Sn_{1+z}$; and has $\sigma$, y, and z allowing the material to fall within the region surrounded by (Fe, Ti, Sn) = (50, 37, 13), (50, 14, 36), (45, 30, 25), (39.5, 25, 35.5), (54, 21, 25), and (55.5, 25, 19.5) {excluding (50, 25, 25)} by at% in an Fe-Ti-Sn ternary alloy phase diagram.

Furthermore, the present invention is a thermoelectric conversion module having a p-type thermoelectric conversion section and an n-type thermoelectric conversion section, wherein each of the p-type thermoelectric conversion section and the n-type thermoelectric conversion section: is a full-Heusler alloy; is represented by the composition formula $Fe_{2+\sigma}Ti_{1+y}Si_{1+z}$; and has σ, y, and z allowing the material to fall within the region surrounded by (Fe, Ti, Si) = (50, 37, 13), (50, 14, 36), (45, 30, 25), (39.5, 25, 35.5), (54, 21, 25), and (55.5, 25, 19.5) {excluding (50, 25, 25)} by at% in an Fe-Ti-Si ternary alloy phase diagram.

The present invention makes it possible to provide: a thermoelectric conversion material that is a material comprising elements less poisonous than Te and has a Seebeck coefficient comparable to BiTe; and a thermoelectric conversion module having a thermoelectric conversion efficiency comparable to the case of using BiTe by using the thermoelectric conversion material.

Other problems, configurations, and effects than described above will be obvious through the following explanations on the embodiments.

## BRIEF DESCRIPTION OF THE DRAWINGS

Figs. 1A and 1B comprise schematic views of a thermoelectric conversion module according to Embodiment 1; Fig. 1A shows the state before an upper substrate is attached and Fig. 1B shows the state after the upper substrate is attached.

Figs. 2A and 2B comprise views showing the results of electron states of full-Heusler alloys obtained by a first principle computation; Fig. 2A is the case of an $Fe_2VAl$ alloy and Fig. 2B is the case of an $Fe_2TiSi$ alloy or an $Fe_2TiSn$ alloy.

Fig. 3A is a view showing a VEC dependency (calculated value) of a Seebeck coefficient estimated from the band structure of an $Fe_{16}Ti_8Si_8$ alloy.

Fig. 3B is a view showing a VEC dependency (calculated value) of a Seebeck coefficient estimated from the band structure of an $Fe_{16}Ti_7Si_9$ alloy.

Fig. 3C is a view showing a VEC dependency (calculated value) of a Seebeck coefficient estimated from the band structure of an $Fe_{16}Ti_9Si_7$ alloy.

Fig. 3D is a view showing a VEC dependency (calculated value) of a Seebeck coefficient estimated from the band structure of an $Fe_{15}Ti_8Si_9$ alloy.

Fig. 3E is a view showing a VEC dependency (calculated value) of a Seebeck coefficient estimated from the band structure of an $Fe_{15}Ti_9Si_8$ alloy.

Fig. 3F is a view showing a VEC dependency (calculated value) of a Seebeck coefficient estimated from the band structure of an $Fe_{17}Ti_7Si_8$ alloy.

Fig. 3G is a view showing a VEC dependency (calculated value) of a Seebeck coefficient estimated from the band structure of an $Fe_{17}Ti_8Si_7$ alloy.

Fig. 4A is a view showing the variation of a Seebeck coefficient to the modulation quantity of a composition modulated from a stoichiometric composition (replacement of Si increase and Fe decrease).

Fig. 4B is a view showing the variation of a Seebeck coefficient to the modulation quantity of a composition modulated from a stoichiometric composition (replacement of Ti increase and Fe decrease).

Fig. 4C is a view showing the variation of a Seebeck coefficient to the modulation quantity of a composition modulated from a stoichiometric composition (replacement of Si increase and Ti decrease).

Fig. 4D is a view showing the variation of a Seebeck coefficient to the modulation quantity of a composition modulated from a stoichiometric composition (replacement of Ti increase and Si decrease).

Fig. 4E is a view showing the variation of a Seebeck coefficient to the modulation quantity of a composition modulated from a stoichiometric composition (replacement of Fe increase and Si decrease).

Fig. 4F is a view showing the variation of a Seebeck coefficient to the modulation quantity of a composition modulated from a stoichiometric composition (replacement of Fe increase and Ti decrease).

Fig. 5 is a ternary alloy phase diagram of an Fe-Ti-Si system full-Heusler alloy and shows the range in which the improvement effect of a Seebeck coefficient is estimated to be high by numerical computation.

Fig. 6 is a ternary alloy phase diagram showing the composition range of an Fe-Ti-Si system full-Heusler alloy according to Embodiment 1.

Fig. 7 is a graph showing the relationship between a Seebeck coefficient and a VEC in an Fe-Ti-Si system full-Heusler alloy according to Embodiment 1.

Figs. 8A to 8c comprise top views of a thermoelectric conversion module; Fig. 8A is a general schematic view, Fig. 8B shows a p-type thermoelectric conversion section, and Fig. 8C shows an n-type thermoelectric conversion section.

Fig. 9 is a graph showing the results of computing the change of outputs obtained when the ratio of the sectional area of a p-type thermoelectric conversion section to the sum (gross sectional area) of the sectional area of the p-type thermoelectric conversion section and the sectional area of an n-type thermoelectric conversion section is changed variously by using L as the parameter.

Fig. 10 is a graph showing the results of computing the change of outputs obtained when the value of L is changed variously by using the ratio of the area of a p-type thermoelectric conversion material to a gross sectional area as the parameter.

Fig. 11 is a graph showing the results of computing the change of outputs obtained when the ratio between L and the square root of the sectional area of an n-type thermoelectric conversion section is changed variously by using the ratio of the area of a p-type thermoelectric conversion material to a gross sectional area as the parameter.

Fig. 12 is a graph showing the results of computing the change of outputs obtained when the ratio between L and the square root of the sectional area of an n-type thermoelectric conversion section is changed variously by using L as the parameter.

Fig. 13 comprises views showing band structures (upper stages) and the $\Delta$VEC dependencies of Seebeck coefficients and the $\Delta$VEC dependencies of normalized power factors (lower stages) in the case of $Fe_{2+\sigma}(Ti_{1-x}M_x)_{1+y}(Si_{1-w}N_w)_{1+z}$ and $(\sigma, y, z) = (0, 0, 0)$; (a) and (d) represent the case of x =0.5, (b) and (e) represent the case of x =0.25, and (c) and (f) represent the case of x =0.125.

Fig. 14 is a graph showing the relationship between a Seebeck coefficient and a $\Delta$VEC in a thermoelectric conversion material according to Embodiment 3.

DETAILED DESCRIPTION OF THE PREFERRED EMBODIMENTS

(Embodiment 1)

<Module configuration>

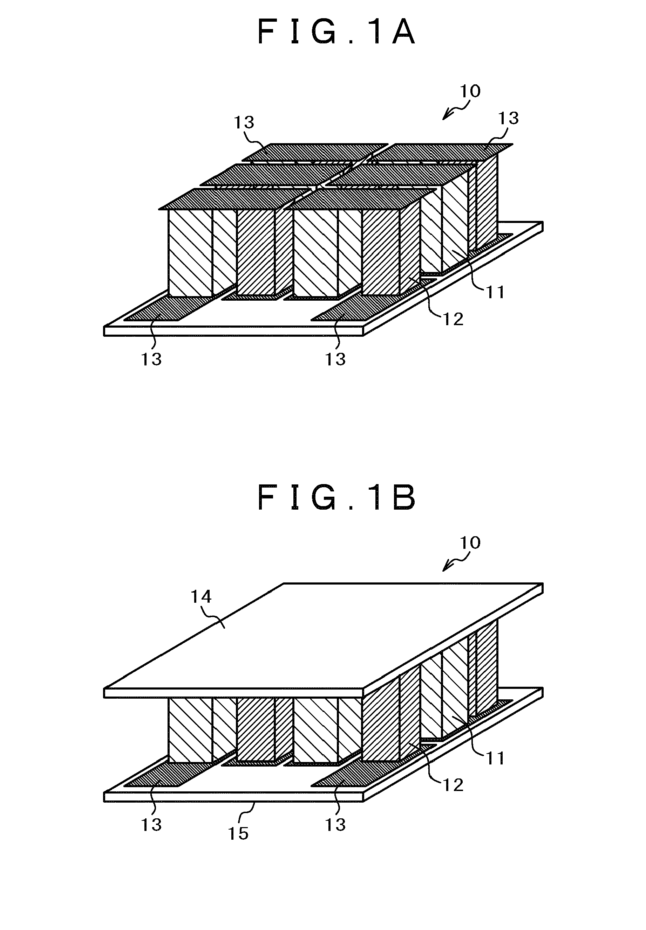

Figs. 1A and 1B are schematic views of a thermoelectric conversion module 10 according to Embodiment 1 of the present invention, and Fig. 1A shows the state before an upper substrate 14 is attached and Fig. 1B shows the state after the upper substrate 14 is attached. The thermoelectric conversion module 10: has p-type thermoelectric conversion sections 11 formed by using a p-type thermoelectric conversion material, n-type thermoelectric conversion sections 12 formed by using an n-type thermoelectric conversion material, electrodes 13, an upper substrate 14, and a lower substrate 15; and is configured by combining the parts. Although it is not shown in the figures, a skeleton is provided in the manner of covering the assembled parts and parts of the electrodes 13 are extracted outside the skeleton in order to take out electricity from the thermoelectric conversion sections.

The p-type thermoelectric conversion sections 11 and the n-type thermoelectric conversion sections 12 are joined through the electrodes 13 and arrayed alternately so as to be electrically connected in series. A set formed by connecting a p-type thermoelectric conversion section 11 and an n-type thermoelectric conversion section 12 in series is called a pn element. The pn elements are installed between the substrates in the manner of vertically interposing the pn elements with the upper substrate 14 and the lower substrate 15. The module is structured so that heat may be transferred to the thermoelectric conversion sections through the upper substrate 14 and the lower substrate 15. In this way, the thermoelectric conversion sections are arrayed electrically in series and thermally in parallel.

<Principle of improving conversion performance>

The principle of improving the conversion performance of a thermoelectric conversion material is explained hereunder. Many material candidates substituting for a BiTe alloy have heretofore been studied and, among them, materials named as candidate materials in a low temperature region are some of full-Heusler alloys. A full-Heusler alloy having the thermoelectric conversion performance and being represented by $Fe_2VAl$ (Fe: iron, V: vanadium, and Al: aluminum) has an electron state called a pseudo gap. In order to explain how the pseudo gap is related to the thermoelectric conversion performance, the general relationship between thermoelectric conversion performance and an electron state is explained.

The performance index of a thermoelectric conversion material is defined by a non-dimensional numeral called ZT and is given by the following formula (1).

$$ZT = \frac{S^2}{\kappa\rho}T \qquad \ldots(1)$$

S: Seebeck coefficient, $\kappa$: heat conductivity, $\rho$: electric resistivity, T = room temperature (300 K)

As the Seebeck coefficient S increases or the electric resistivity $\rho$ and the heat conductivity $\kappa$ decrease, the performance index increases. The Seebeck coefficient S and the electric resistivity $\rho$ are physical quantities decided by the electron state of a material. The Seebeck coefficient S has the relationship represented by the following formula (2).

$$S \propto \frac{1}{N(E_F)}\left(\frac{\partial N(E)}{\partial E}\right)_{E \sim E_F} \qquad \ldots(2)$$

E: binding energy, N: state density

According to formula (2), the Seebeck coefficient S is inversely proportional to the absolute value of the state density N in a Fermi level and is proportional to the energy gradient thereof. It is obvious therefore that a material having a small state density in the Fermi level and having a rapidly changing rise of the state density has a high Seebeck coefficient S.

Meanwhile, the electric resistivity p has the relationship represented by the following formula (3).

$$\frac{1}{\rho} \propto \lambda_F v_F N(E_F) \qquad \ldots(3)$$

$\lambda_F$: average free path of electrons in a Fermi level $v_F$: velocity of electrons in a Fermi level

According to formula (3), since the electric resistivity $\rho$ is inversely proportional to the state density N, the electric resistivity $\rho$ is small when the Fermi level is at an energy position where the absolute value of the state density N is large.

Here, let's go back to the discussion on a pseudo gap electron state. The band structure of a pseudo gap is an electron state where the state density in the vicinity of a Fermi level decreases extremely. Further, as a feature of the band structure of an Fe$_2$VAl system alloy, it is said that the Fe$_2$VAl system alloy behaves like a rigid band model, which means that, when the composition ratio of the chemical compound is changed, the band structure does not change largely and only the energy position of the Fermi level changes. In an Fe$_2$VAl system alloy therefore, it is possible to control the Fermi level at an energy position allowing the state density to change steeply and the absolute value of the state density to be optimized either by changing the composition ratio of the chemical compound or by changing the composition of the chemical compound and applying electron doping or hole doping. It is possible thereby to optimize the relationship between a Seebeck coefficient and a resistivity. The electron doping or the hole doping can be controlled on the basis of a VEC (Valence Electron Concentration: valence electron number per one atom) computed from the composition ratio of a chemical compound. A VEC is defined as a value obtained by dividing the total valence electron number Z in a chemical compound by the atom number a in a unit cell. In the case of Fe$_2$VAl for example, the valence electron numbers of the elements are Fe: 8, V: 5, and Al: 3, the atom numbers of the elements in a unit cell are Fe: 2, V: 1, and Al: 1, and hence Z is computed as Z = 8X2+5X1+3X1 =24. Further, a is computed as a = 2+1+1 and hence VEC =6 is obtained. When the composition ratio of a chemical compound is varied, the value of a VEC increases or decreases. It is known that the increase and the decrease of a VEC are approximately equivalent to electron doping and hole doping in the aforementioned rigid band model and it is possible to change the value and the polarity of the Seebeck coefficient by the control of the VEC. Concretely, when the VEC is less than 6, it can be regarded as hole doping and hence a p-type thermoelectric conversion material is obtained. In contrast, when the VEC is not less than 6, an n-type thermoelectric conversion material is obtained. Further, it is known that each of the p-type and the n-type bears the maximum Seebeck coefficient in the vicinity of the VEC from a preceding example of continuously changing the VEC in the vicinity of 6. In this way, an Fe$_2$VAl system alloy is a material system allowing both the p-type and the n-type to be obtained. Then by actively using an energy level generating a steep change of a state density allowing Fe$_2$VAl to exhibit thermoelectric conversion performance by the modulation of the constituent composition and VEC control by an added element, further improvement of performance can be expected.

A heat conductivity κ can be regarded as the sum of a lattice heat conductivity κp to transfer heat through lattice vibration and an electron heat conductivity κe to transfer heat by using electrons as a medium. With regard to κe, the value increases as the electric resistivity decreases by the Wiedemann-Franz law and depends on a pseudo gap electron state. The electron heat conductivity κe can decrease by controlling a carrier density and generally, when a carrier density is smaller than $10^{20}/cm^3$, κe comes to be minimum and κp comes to be dominant. Since the decrease of a carrier density simultaneously causes the increase of an electric resistivity however, from the definition of ZT, it is estimated that ZT responding to a carrier density has a maximum value by the balance between the increase of an electric resistivity and the decrease of a heat conductivity. On the other hand, it has been known from the following formula (4) that κp depends on the magnitude of a lattice. Summing up the above discussion, the heat conductivity κ can be expressed as follows.

$$\kappa = k_f \times C_p \times \varsigma \quad \dots (4)$$

$$k_f = \frac{d^2}{\tau_f} \quad \dots (5)$$

$\varsigma$ : density of material, d: particle size, $C_p$: specimen constant pressure specific heat, $\tau_f$: time spent during heat transfer from bottom face to top face of particle

As shown in formulas (4) and (5), it is obvious that a heat conductivity κ decreases as the particle size of a specimen decreases. In this way, in a full-Heusler alloy, it is possible to dramatically improve thermoelectric conversion performance by controlling the electron state of the alloy and decreasing a specimen particle size.

In view of the above situation, the present inventors have adopted a full-Heusler alloy as a thermoelectric conversion material. The present inventors have decided to use an $Fe_2TiSi$ alloy or an $Fe_2TiSn$ alloy as the material of a p-type thermoelectric conversion section 11 and the material of an n-type thermoelectric conversion section 12 respectively. An $Fe_2TiSi$ alloy or an $Fe_2TiSn$ alloy has a high Seebeck coefficient in both the p-type and the n-type by giving appropriate composition and added element quantity.

In a pseudo gap structure to decide the thermoelectric conversion characteristic of a full-Heusler alloy, a specific band structure called a flat band exists. It is estimated that the flat band mostly decides a thermoelectric conversion material. By controlling a flat band in an appropriate state therefore, it is possible to propose a novel thermoelectric conversion material having an improved thermoelectric conversion characteristic.

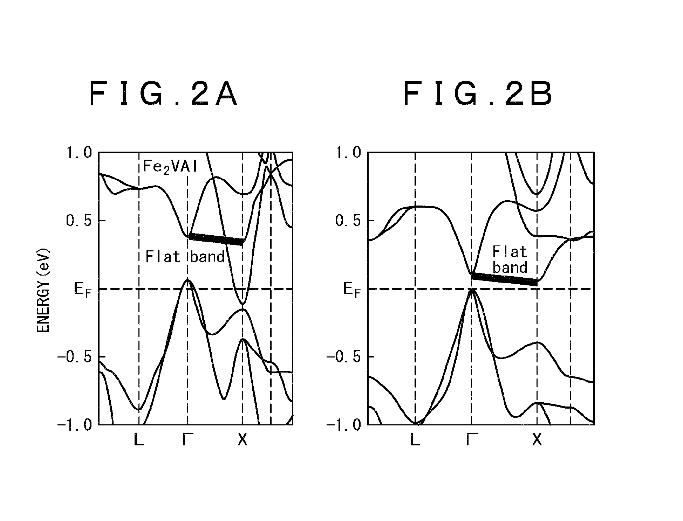

Figs. 2A and 2B are views showing the results of obtaining the electron states of full-Heusler alloys by the first principle computation. Fig. 2A shows the electron state of $Fe_2VAl$ and Fig. 2B shows the electron state of an $Fe_2TiSi$ alloy or an $Fe_2TiSn$ alloy that is a full-Heusler alloy according to an embodiment of the present invention.

As shown in Figs. 2A and 2B, it is possible to bring a flat band close to the vicinity of a Fermi level by changing the alloy composition from $Fe_2VAl$ to an $Fe_2TiSi$ alloy or an $Fe_2TiSn$ alloy. As a result, it is possible to steeply change the state density in the vicinity of the Fermi level. A thermoelectric conversion characteristic, particularly a Seebeck coefficient, thereby improves. Further, there is the advantage that the gap value of a pseudo gap can be controlled to a small value and hence an electric resistivity does not increase.

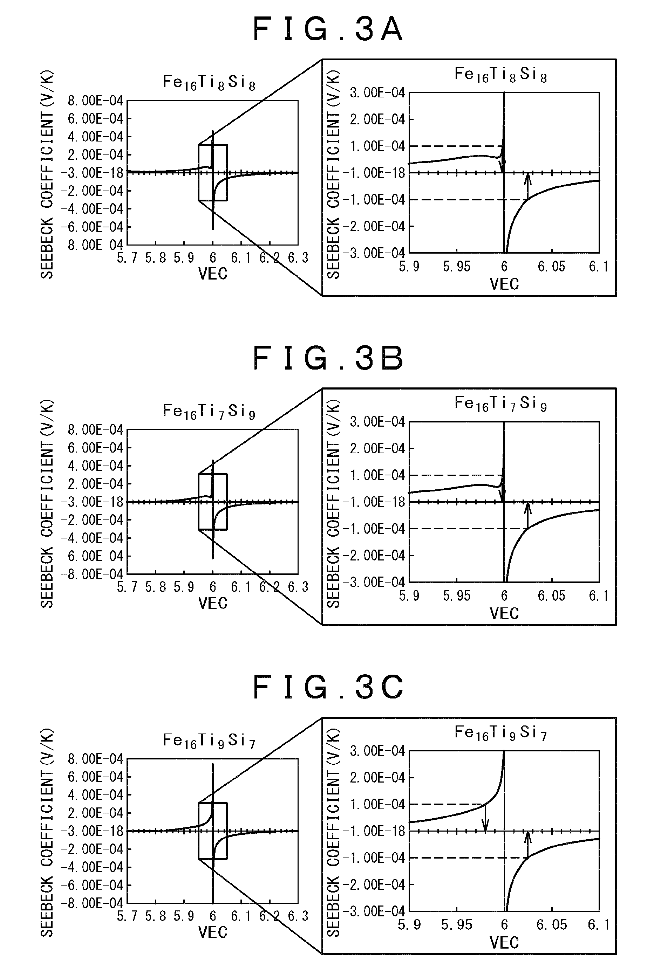

The calculated values of Seebeck coefficients estimated from such band structures are shown in Figs. 3A to 3G. Each of Figs. 3A to 3G represents the VEC dependency of the Seebeck coefficient computed by using the first principle computation. Fig. 3A shows the result of computation on the stoichiometric composition ($Fe_2TiSi$) of an Fe-Ti-Si full-Heusler alloy. This means the Seebeck coefficient computed from the band structure shown in Fig. 2B. From the computation result, it is obvious that the Seebeck coefficient comes to be the maximum value by selecting an appropriate VEC value and a p-type and an n-type are obtained in the same manner as the case of $Fe_2VAl$. The values of the computed Seebeck coefficients S are S = +400 uV/K in the case of the p-type and S =-600 uV/K in the case of the n-type and it is obvious that the performance improves more than three times the conventional $Fe_2VAl$ system full-Heusler alloy. The increase of the Seebeck coefficient corresponds to the improvement of more than nine times in terms of ZT. Further, it is found that the range exceeding the Seebeck coefficient |S| =100 uV/K allowing a practicable ZT is VEC =- 0.02 to 0.25 to the VEC center value. Successively, the electron state computation results of non-stoichiometric compositions obtained by arbitrarily deviating the composition ratio of Fe, Ti, and Si from the stoichiometric composition are shown in Figs. 3B to 3G (here, the same holds when Sn is used in place of Si, and also the same holds when SiSn is used in place of Si). Concretely, the compositions formed by replacing one atom from the stoichiometric composition

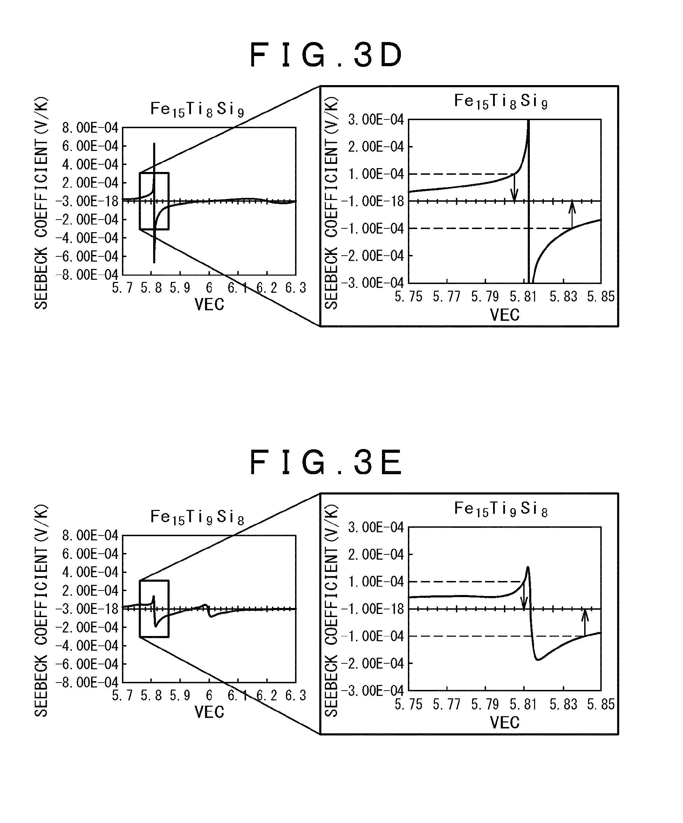

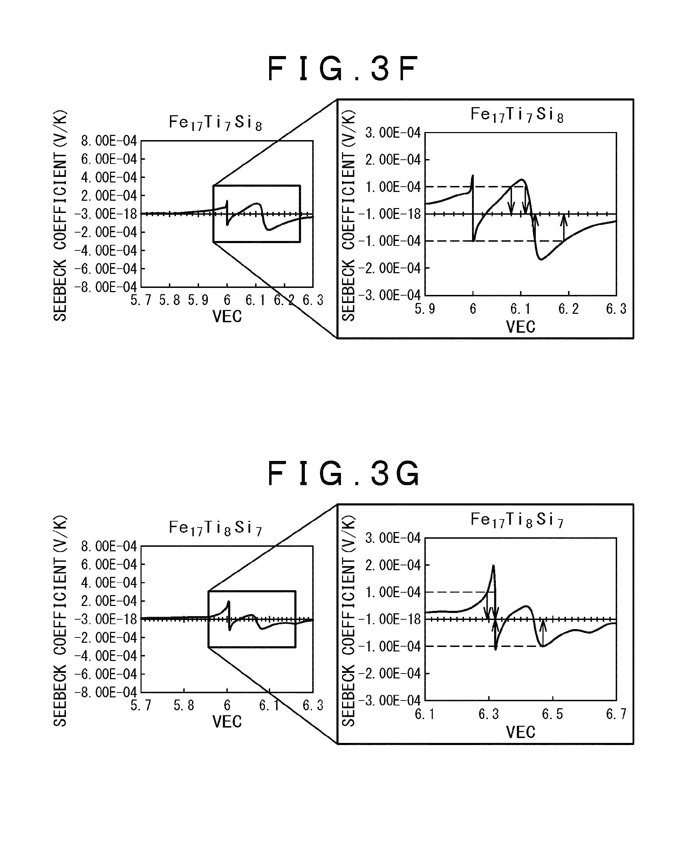

$Fe_{16}Ti_8Si_8$ on the assumption of a 32 atom system are computed. In the cases of Figs. 3B to 3G, the electron state computation is carried out on the following compositions Fig. 3B: $Fe_{16}Ti_7Si_9$, Fig. 3C: $Fe_{16}Ti_9Si_7$, Fig. 3D: $Fe_{15}Ti_8Si_9$, Fig. 3E: $Fe_{15}Ti_9Si_8$, Fig. 3F: $Fe_{17}Ti_7Si_8$, and Fig. 3G: $Fe_{17}Ti_8Si_7$. Even in the cases of employing non-stoichiometric compositions, the Seebeck coefficients are large and the levels of about 2.5 to 3 times the conventional $Fe_2VAl$ system full-Heusler alloy are maintained. It is found therefore that the performance does not deteriorate by selecting an appropriate composition ratio even when a composition is modulated from the stoichiometric composition to the extent of the modulation quantities of the aforementioned non-stoichiometric compositions.

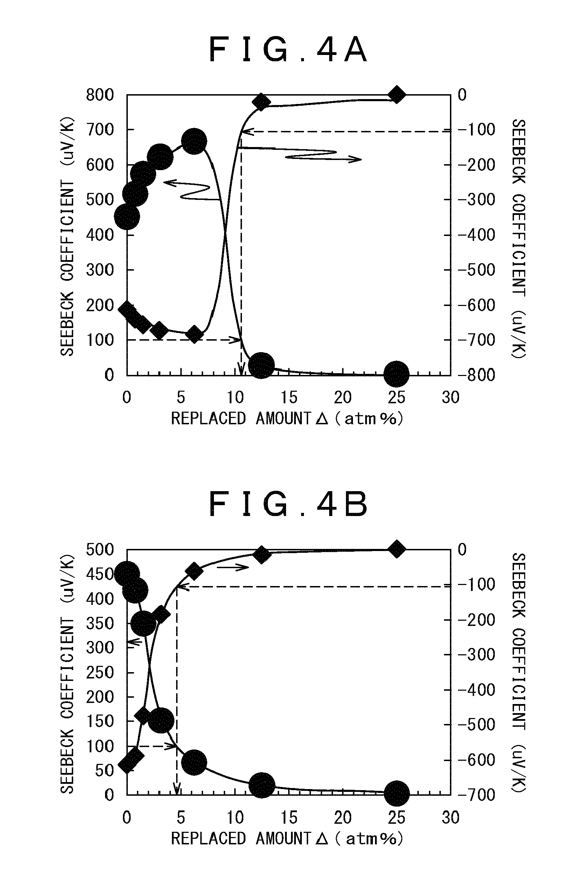

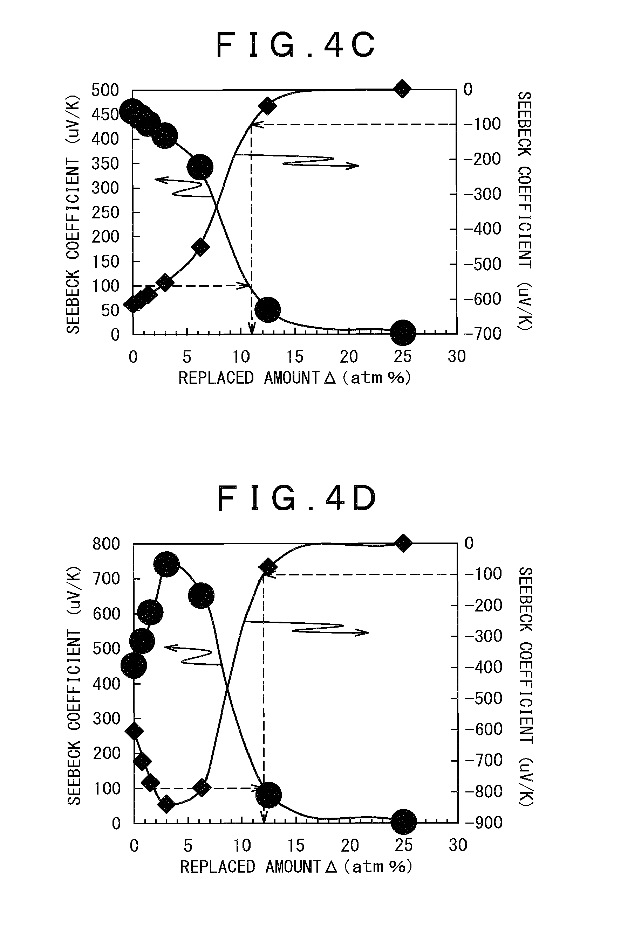

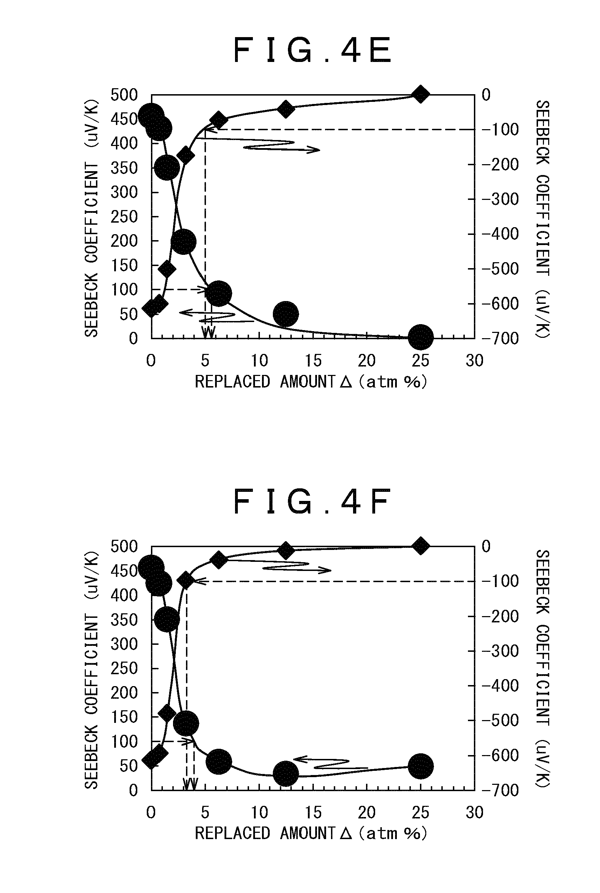

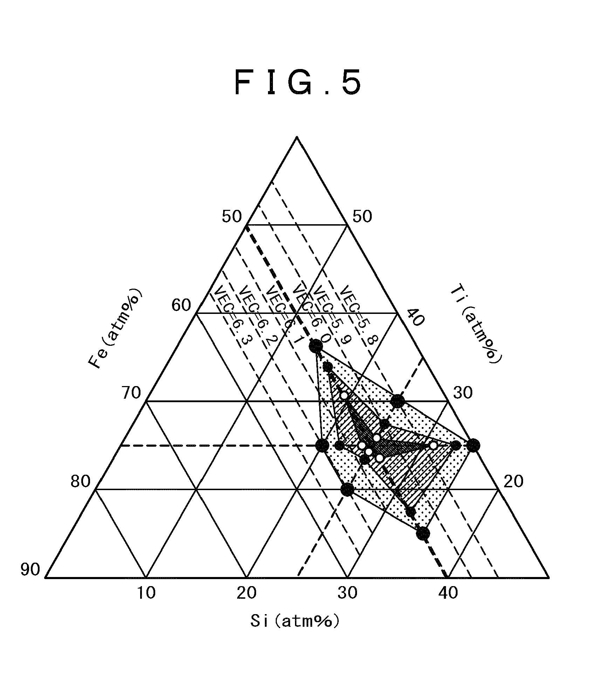

Further, it is found through the studies by the present inventors that the maximum value of a Seebeck coefficient increases by a modulation method from the stoichiometric composition to a non-stoichiometric composition in an Fe-Ti-Si Heusler alloy and hence that is explained. Furthermore, it is found through the studies by the present inventors that practically sufficient performance is obtained by the modulation from the stoichiometric composition to a non-stoichiometric composition in an Fe-Ti-Si Heusler alloy and hence that is also explained together. The plots of the variations of the Seebeck coefficients to the modulation quantities from the stoichiometric composition to non-stoichiometric compositions in an Fe-Ti-Si Heusler alloy are shown in Figs. 4A to 4F. Here, in a vertical axis in each of Figs. 4A to 4F, the left side shows a Seebeck coefficient in the case of a p-type and the right side shows a Seebeck coefficient in the case of an n-type. The computation results are the results of obtaining the electron states of the systems formed by replacing one element and obtaining the Seebeck coefficients for the 4, 8, 16, 64, and 128 atom systems in the same manner as the computation result of the 32 atom system. Since the atomic ratio corresponding to one atom changes in response to the number of all atoms, a replaced quantity can be described by at%. In each of the cases of 4 and 8 atom systems, the replacement of one atom largely changes the symmetric property of a crystal system. In the 4 atom system for example, when Fe and Ti are replaced with each other in $Fe_2TiSi$, $Fe_2TiSi$ turns to $Fe_3Si$ or $FeTi_2Si$ and a different crystal system is obtained. That means that the electron state deviates largely from the electron state shown in Fig. 2B and hence it is found that the absolute value of the Seebeck coefficient decreases conspicuously. In the 8 atom system likewise, it is found that an atomic arrangement likely to create a metallic electron state in a unit cell by the conspicuous change of the symmetric property of the crystal structure is formed undesirably and the absolute value of the Seebeck coefficient decreases. From Figs. 4A to 4F, an acceptable replaced quantity having a Seebeck coefficient exceeding ZT =1 that is a practicable level is, in each of the replacement modes, 10.8 at% in the case of Ti: stoichiometric composition, Si increase, and Fe decrease (Fig. 4A), 4.9 at% in the case of Si: stoichiometric composition, Ti increase, and Fe decrease (Fig. 4B), 11 at% in the case of Fe: stoichiometric composition, Ti decrease, and Si increase (Fig. 4C), 12.0 at% in the case of Fe: stoichiometric composition, Ti increase, and Si decrease (Fig. 4D), 5.9 at% in the case of Ti: stoichiometric composition, Fe increase, and Si decrease (Fig. 4E), and 4.0 at% in the case of Si: stoichiometric composition, Fe increase, and Ti decrease (Fig. 4F). The result of showing the appropriate composition range found from the replaced quantities on a ternary alloy phase diagram is Fig. 5. The region surrounded by the points representing, on the ternary alloy phase diagram, 12.0 at% in the case of Fe: stoichiometric composition, Ti increase, and Si decrease, 11 at% in the case of Fe: stoichiometric composition, Ti decrease, and Si increase, 4.9 at% in the case of Si: stoichiometric composition, Ti increase, and Fe decrease, 10.8 at% in the case of Ti: stoichiometric composition, Si increase, and Fe decrease, 4.0 at% in the case of Si: stoichiometric composition, Fe increase, and Ti decrease, and 5.9 at% in the case of Ti: stoichiometric composition, Fe increase, and Si decrease can be said as the appropriate range. The points are expressed by atm% as follows; (Fe, Ti, Si) = (50, 37, 13), (50, 14, 36), (45, 30, 25), (39.5, 25, 35.5), (54, 21, 25), and (55.5, 25, 19.5).

By observing the relationship between an Si increment and a Seebeck coefficient shown in Fig. 4A in particular, an unprecedented knowledge that the Seebeck coefficient improves more in the case of decreasing Fe intentionally (increasing Si intentionally) than in the case of the stoichiometric composition is obtained. Concretely, it is found that a thermoelectric conversion material having an improved Seebeck coefficient can be obtained by a composition formed by decreasing Fe by 1 to 9 at% (increasing Si by 1 to 9 at%) from the stoichiometric composition, namely a composition in the relationship of y =0, $\sigma$ = -z, and -0.36$\leq$ $\sigma$ $\leq$-0.04 rather than the stoichiometric composition of $\sigma$= y = z =0 in terms of the composition formula $Fe_{2+\sigma}Ti_{1+y}Si_{1+z}$. $\sigma$ is preferably in the range of -0.32$\leq$ $\sigma$ $\leq$-0.08.

Further, by observing the relationship between a Ti increment and a Seebeck coefficient shown in Fig. 4D, an unprecedented knowledge that the Seebeck coefficient improves more in the case of increasing Ti intentionally than in the case of the stoichiometric composition is obtained. Concretely, it is found that a thermoelectric conversion material having an improved Seebeck coefficient can be obtained by a composition formed by increasing Ti by 1 to 8 at% from the stoichiometric composition, namely a composition in the relationship of $\sigma$ =0, y = -z, and 0.04$\leq$ y $\leq$0.32 rather than the stoichiometric composition of $\sigma$ = y = z =0 in terms of the composition formula $Fe_{2+\sigma}Ti_{1+y}Si_{1+z}$. y is preferably in the range of 0.08$\leq$ y $\leq$0.28.

Further, the characteristic is particularly good in the range surrounded by the straight lines connecting the 6 points of (Fe, Ti, Si) = (39.5, 25, 35.5), (47.5, 27.5, 25), (50, 17, 33), (50, 35, 15), (52.8, 25, 22.2), and (52.2, 22.8, 25) in atm% on the ternary alloy phase diagram. Furthermore, the region of better characteristics than the stoichiometric composition is the region surrounded by the straight lines connecting the following 6 points of (Fe, Ti, Si) = (41, 25, 34), (49.2, 25.8, 25), (50, 23, 27), (50, 32.6, 17.4), 51, 25, 24), and (51, 24, 25). It is found that an Fe-Ti-Si system alloy that is a novel material formed by synthesizing an alloy in the range shown in Fig. 5 has far better performance than a conventional material. This can be said also in the case of Fe-Ti-Sn, Fe-Nb-Al, or an intermediate material thereof by the similar electron state computation. Moreover, high performance can be obtained by replacing or adding a specific element to an Fe-Ti-Si Heusler alloy of a non-stoichiometric composition for VEC adjustment.

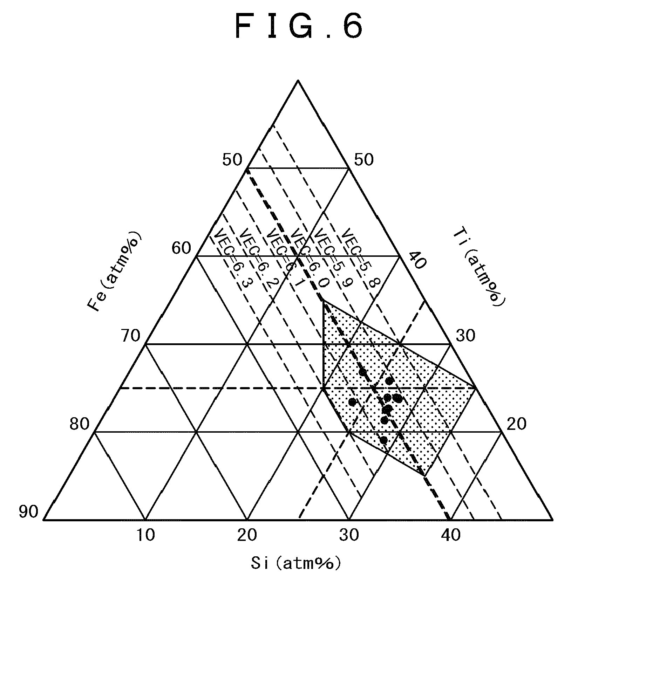

A definitional formula of a VEC is introduced from a composition formula of an Fe-Ti-Si Heusler alloy in order to define the quantity of a replaced element causing an appropriate VEC variation in VEC control. Firstly, the composition formula of the Fe-Ti-Si Heusler alloy is set at $Fe_{2+\sigma}(Ti_{1-x}M_x)_{1+y}(Si_{1-w}N_w)_{1+z}$. The VEC = [8(2+$\sigma$)+{4(1-x) + (valence electron number of M) x} (1+y)+{4(1-w)+(valence electron number of N)w}(1+z)]/4, $\sigma$ = {(at% of Fe in the region of Fig. 6)-50}/25, y = {(at% of Ti in the region of Fig. 6)-25}/25, and z = {(at% of Si in the region of Fig. 6)-25}/25 are obtained and, when the variation of a VEC is defined as $\Delta$VEC, the $\Delta$VEC = VEC-(VEC center value of each mother alloy composition) is obtained.

The |$\Delta$VEC| is preferably in the range of 0.001$\leq$ |$\Delta$VEC| $\leq$0.09 and a thermoelectric conversion material of a large Seebeck coefficient can be obtained.

A maximum value is obtained in both the cases of a p-type and an n-type by adding at least any one of Nb, V, Al, Ta, Cr, Mo, W, Hf, Ge, Ga, In, P, B, Bi, and Zr as each of M and N so that a $\Delta$VEC may be at most not more than $\pm$0.2 (-0.2$\leq$ $\Delta$VEC $\leq$0.2). Here, the VEC center value of each mother alloy composition means the VEC value obtained when x and w are 0 and 0 respectively. From the VEC dependency of the Seebeck coefficient indicated in each of Figs. 3A and 3G, a VEC comes to be an optimum value if at most |$\Delta$VEC| $\leq$0.2 is satisfied. In order to optimize a VEC, it is acceptable if the combination of the alloy composition components x and w and the replaced materials M and N is selected so that |$\Delta$VEC| $\leq$0.2 may be satisfied by adding at least any one of Nb, V, Al, Ta, Cr, Mo, W, Hf, Ge, Ga, In, P, B, Bi, and Zr. In order to improve a Seebeck coefficient, x and w are preferably at least in either of the ranges of 0.05$\leq$ x $\leq$0.5 and 0.05$\leq$ w $\leq$0.5. The effect of V (vanadium) replacement is particularly recognized and the optimum replaced quantity x is |x| $\leq$0.25.

Here, in the case of adding at least any one of Nb, V, Ta, Cr, Mo, W, Hf, Ge, Ga, In, P, B, Bi, and Zr as an added material for adjusting the quantity of total electrons too, a characteristic similar to Fig. 2B is obtained. Further, since Si and Sn are elements belonging to an identical group in the periodic table, even when the composition ratios of those elements are changed, a characteristic similar to Fig. 2B is obtained.

In the present embodiment, in the alloy composition range suggested by the first principle computation shown in Figs. 3A to 3G, a synthesizable range and an optimum composition range are confirmed by: selecting alloy compositions that can be manufactured practically and have high-performance thermoelectric conversion characteristics; and synthesizing some of them. In an $Fe_2TiSi$ system alloy in particular, since the flat band is in the vicinity of the Fermi level as shown in the band diagram of Fig. 2B, the thermoelectric conversion efficiency is very high. In the present embodiment therefore, it is attempted to provide a thermoelectric conversion module having a high conversion efficiency by adopting $Fe_{2+\sigma}$ $(Ti_{1-x}M_x)_{1+y}$ $(Si_{1-w}N_w)_{1+z}$ as an n-type thermoelectric conversion material.

<Configuration example of thermoelectric conversion module 10>

The configuration example of a thermoelectric conversion module 10 manufactured in accordance with the aforementioned principle is explained hereunder. Here, an $Fe_2TiSiSn$ system alloy is used as the material of a p-type thermoelectric conversion section 11 and an n-type thermoelectric conversion section 12. Ta is used as the material of an electrode 13 and AlN is used as the material of an upper substrate 14 and a lower substrate 15. As the material of a skeleton, any material is acceptable as long as it is a material having a high heat conductivity and a high strength. Steel is used here.

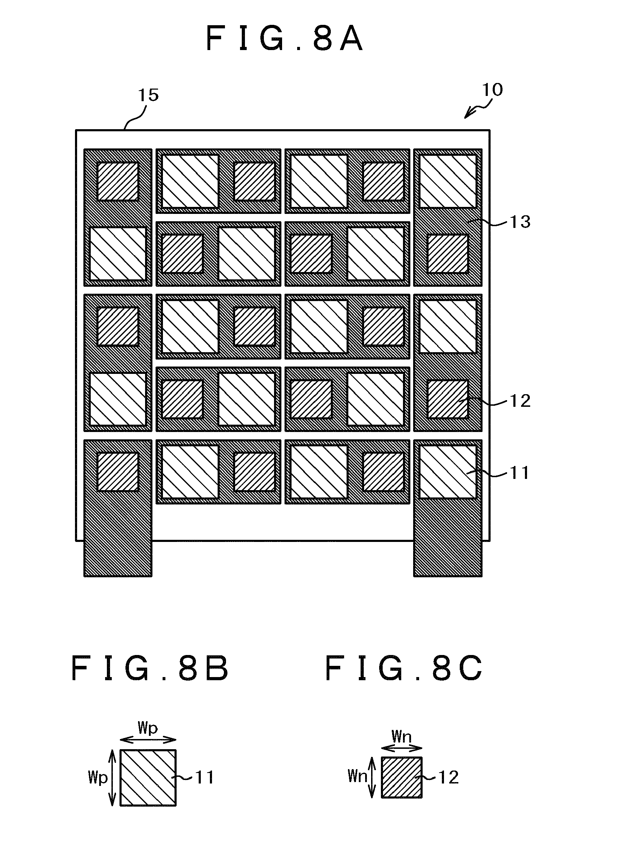

Fig. 8A comprises top views of the thermoelectric conversion module 10. Fig. 8A is a view viewed from above in the normal direction of a substrate over which thermoelectric conversion sections are installed. Figs. 8B and 8C show the definition of the dimensions of respective thermoelectric conversion sections. Both the vertical and horizontal sizes of the p-type thermoelectric conversion section 11 in a cross section are set at Wp and both the vertical and horizontal sizes of the n-type thermoelectric conversion section 12 in a cross section are set at Wn. The length (length in the normal direction of the substrate) of the n-type thermoelectric conversion section is set at L. As an example of the sizes, L =6 mm, Wp =10 mm, and Wn =3 mm can be adopted for example.

Each of the thermoelectric conversion sections can be manufactured by a sintering method with a hot press. The weights of the powder of elements to be the material are adjusted and then the material is fed into a carbon die and sintered so that the element composition ratio of the alloy may meet a design.

In the case of manufacturing an $Fe_2TiVSi$ system alloy for example, the powder of the elements Fe, Ti, V, and Si is weighed so that the element composition ratio may meet the design and is fed into a carbon die. For example, it is possible to prepare a material so as to satisfy, in $Fe_{2+\sigma}$ $(Ti_{1-x}M_x)_{1+y}(Si_{1-w}N_w)_{1+z}$, Fe:Ti:V:Si = 1.98:0.855:0.095:1.07 ($\sigma$ =-0.02, x =0.1, y =-0.05, z =0.07, and w =0). Successively, the material is reacted and sintered at 800°C for 5,000 seconds for example. Further, it is also possible to apply heating treatment at 600°C for 2 days for example in order to improve the regularity of the crystal structure of the sintered body finished by the reaction and sintering. In the present composition, by mixing V as an additive material, it is attempted to improve the performance of a thermoelectric conversion material and stabilize the crystal structure. The pellets thus manufactured are processed into the aforementioned sizes and mounted on the thermoelectric conversion module 10.

Although $Fe_{2+\sigma}(Ti_{1-x}M_x)_{1+y}(Si_{1-w}N_w)_{1+z}$ is adopted as the material of the p-type thermoelectric conversion section 11 in the aforementioned configuration example, the material is not limited to the example and $Fe_2NbAl$, $FeS_2$, or the like can be used for example. The material of the upper substrate 14 and the lower substrate 15 may also be GaN. The material of the electrode 13 may also be Cu or Au.

Although the material composition of the n-type thermoelectric conversion section 12 is $Fe_{1.98}Ti_{0.855}V_{0.095}Si_{1.07}$ in the aforementioned configuration example, the composition is not limited to the composition and may be any composition as long as it is an alloy composition having the characteristic shown in Fig. 2B as a full-Heusler alloy exhibiting an n-type characteristic. For example, an alloy formed by using $Fe_2NbAl$ or $Fe_2TiAl$ as the mother material and adding at least any one of Nb, V, Al, Ta, Cr, Mo, W, Hf, Ge, Ga, In, P, B, Bi, and Zr for VEC adjustment may also be acceptable.

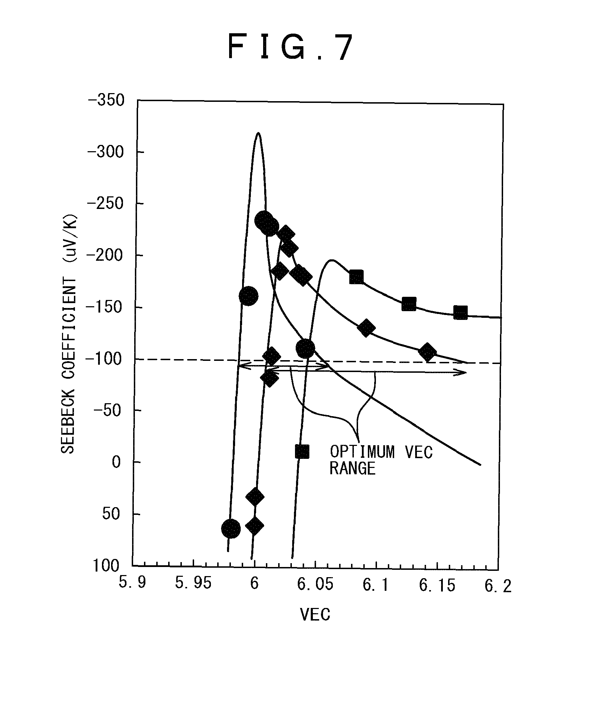

In order to know the full picture of the appropriate composition range, materials of some compositions are synthesized on the basis of Figs. 3A to 3G. The practiced composition range is shown as a ternary alloy phase diagram in Fig. 6 and the relationship between a Seebeck coefficient and a VEC is summarized in Fig. 7 and Table 1.

[Table 1]

| Composition | VEC | S |
|---|---|---|
| $Fe_{2.04}(Ti_{1-x}V_x)_{0.86}Si_{1.1}$ x=0.0 | 6.03922 | -5.2 |
| $Fe_{2.04}(Ti_{1-x}V_x)_{0.86}Si_{1.1}$ x=0.2 | 6.08235 | -162.2 |
| $Fe_{2.04}(Ti_{1-x}V_X)_{0·86}Si_{1.1}$ x=0.4 | 6.12549 | -112.4 |
| $Fe_{2.04}(Ti_{1-x}V_X)_{0.86}Si_{1.1}$ x=0.6 | 6.16863 | -96.2 |
| Composition | VEC | S |
| $Fe_{2.00}(Ti_{1-x})_{0.91}Si_{1.09}$ x=0.0 | 6 | 5.6 |
| $Fe_{2.00}(Ti_{1-x}V_x)_{0.91}Si_{1.09}$ x=0.05 | 6.011 | -83.4 |
| $Fe_{2.00}(Ti_{1-x}V_x)_{0.92}Si_{1.08}$ x=0.08 | 6.019 | -186.2 |
| $Fe_{2.00}(Ti_{1-x}V_x)Si_{1.09}$ x=0.10 | 6.023 | -223 |
| $Fe_{2.00}(Ti_{1-x}V_x)_{0.91}Si_{1.09}$ x=0.15 | 6.034 | -184.4 |
| $Fe_{2.00}(Ti_{1-x}V_x)_{0.91}Si_{1.09}$ x=0.4 | 6.09 | -132.2 |
| $Fe_{2.1}(Ti_{1-x}V_x)_{0.76}Si_{1.75}$ x=0.25 | 6.14 | -109 |
| Composition | VEC | S |
| $Fe_{1.98}(Ti_{1-x}V_x)_{0.95}Si_{1.07}$ x=0.05 | 5.99 | -162.2 |
| $Fe_{1.98}(Ti_{1-x}V_x)_{0.95}Si_{1.07}$ x=0.12 | 6.009 | -230.6 |
| $Fe_{1.91}(Ti_{1-x}V_x)_{1.04}Si_{1.04}$ x=0. 5 | 6.04 | -112.4 |

From the results shown in Figs. 6 and 7 and Table 1, it is confirmed that sufficiently high performance is obtained in the composition range introduced from Figs. 3A to 3G and Figs. 4A to 4F. An optimum quantity of an added material in each of the alloy compositions is understood from the relationship between a Seebeck coefficient and a VEC shown in Fig. 7. An extreme value of the Seebeck coefficient exists at a position where the VEC value deviates slightly from the VEC value (not necessarily VEC = 6 in the case of a non-stoichiometric composition) where the polarity of the Seebeck coefficient is reversed and hence the Seebeck coefficient is particularly high in the case of a composition allowing such a VEC or such an added element quantity. According to actual experimental values, a high thermoelectric conversion characteristic is obtained in the case of a VEC value up to about VEC $=\pm0.2$ from the center value of the VEC. That is, from the example, a VEC comes to be an optimum value when at most $|\Delta VEC| \leq 0.2$ is satisfied. It is only necessary to: select at least any one of Nb, V, Al, Ta, Cr, Mo, W, Hf, Ge, Ga, In, P, B, Bi, and Zr as the replacement element of each of N and M in order to optimize a VEC; and select the combination of the alloy composition components x and w and the replaced material M and N so as to satisfy $|\Delta VEC| \leq 0.2$. The effect of V replacement is particularly recognized and the optimum value of the replaced quantity x is $|x| \leq 0.25$.

Further, when at least any one of Nb, V, Ta, Cr, Mo, W, Hf, Ge, Ga, In, P, B, Bi, and Zr is added as an additive material, it is desirable to configure the material so that the sum of the composition ratios of the additive materials may be smaller than the composition ratio of Ti. The reason is that, if the composition ratio of the additive material is larger, it deviates from the range as an $Fe_2TiSiSn$ system alloy explained in Fig. 2B. Further, it is found that, when a VEC is controlled only by an added element, it is desirable to: compute the sum of the contribution of the VEC by the added element so that the increase and decrease of the VEC value may be $\pm 0.2$; and add at least any one of Nb, V, Ta, Cr, Mo, W, Hf, Ge, Ga, In, P, B, Bi, and Zr. A thermoelectric conversion material introduced in the present embodiment is not necessarily manufactured by the method in the present embodiment and can be manufactured appropriately also by a casting method such as an arc melting method. Furthermore, a thermoelectric conversion material can be manufactured appropriately also by a method of being alloyed by arc melting, being pulverized thereafter, and obtaining a sintered body by hot press or spark plasma sintering. Otherwise, a thermoelectric conversion material can be manufactured appropriately also by a method of manufacturing alloy powder by mechanical alloying when the alloy is manufactured and obtaining a sintered body by hot press or spark plasma sintering. Moreover, an intended alloy can be manufactured also by a thin piece obtained by rapidly cooling the material after it is melted. Moreover, a thermoelectric conversion material can be manufactured appropriately also by a method of powderizing a thin piece obtained by rapidly cooling the material after it is melted and obtaining a sintered body by hot press or spark plasma sintering. Otherwise, a method of obtaining powder by heating raw material powder adjusted to a given composition by thermal plasma and successively rapidly cooling the powder can be adopted appropriately. Then a thermoelectric conversion material can be manufactured appropriately also by a method of obtaining a sintered body by hot press or spark plasma sintering by using the powder obtained by the thermal plasma.

In this way, a thermoelectric conversion module 10 according to Embodiment 1 is formed by using a full-Heusler alloy as the material for each of a p-type thermoelectric conversion section 11 and an n-type thermoelectric conversion section 12 and the material of the n-type thermoelectric conversion section 12 is a full-Heusler alloy of an $Fe_2TiSi$ system, an $Fe_2TiSn$ system, or an $Fe_2TiSiSn$ system. It is thereby possible to provide a less poisonous thermoelectric conversion module having a high thermoelectric conversion efficiency.

(Embodiment 2)

The thermoelectric conversion performance of a thermoelectric conversion module is influenced also by the flow rate Q of the heat flowing into the module besides the conversion efficiency $\eta$ of a thermoelectric conversion material. Since the heat flow rate Q is a variable influenced by the structure (particularly the sizes of the sections) of a thermoelectric conversion module, it is important to design an optimum module structure in response to the characteristic of a selected thermoelectric conversion material. In Embodiment 2 according to the present invention therefore, the optimization of the sizes of sections of a thermoelectric conversion module 10 is examined on the premise of employing a thermoelectric conversion material explained in Embodiment 1. The other configuration of the thermoelectric conversion module 10 is the same as Embodiment 1.

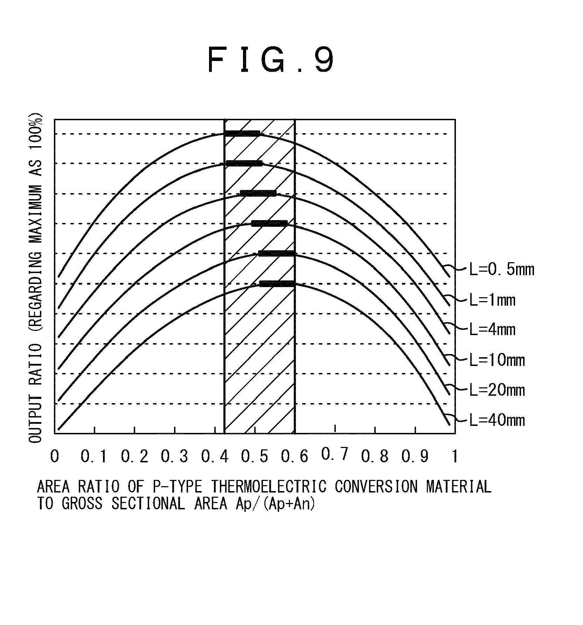

Fig. 9 is a graph showing the results of computing the change of outputs obtained when the ratio of the sectional area of a p-type thermoelectric conversion section 11 and the sectional area of an n-type thermoelectric conversion section 12 is changed variously by using L that is the length of the n-type thermoelectric conversion section as the parameter. As the materials of the thermoelectric conversion sections, the materials explained in the configuration example of Embodiment 1 are adopted and the thermoelectric conversion efficiencies $\eta$ of the materials are used. On the above premise, the temperature difference in the thermoelectric conversion module 10 generated when a high temperature heat source is set at 90°C and a low temperature heat source is set at 20°C and an output generated by the temperature difference are computed. 90°C of the high temperature heat source is the temperature set by assuming a temperature obtained when the exhaust heat from a factory, an electric generation plant, or the like is discharged by using water. The parameter is the same in the following drawings too.

The horizontal axis in Fig. 9 shows the ratio of Ap to the sum (Ap+An) of the sectional area Ap of the p-type thermoelectric conversion section 11 and the sectional area An of the n-type thermoelectric conversion section 12. The vertical axis in Fig. 9 shows the electric power output of one pn element. The output characteristic of a pn element varies also by the value of L and hence similar computations are carried out by using a plurality of L values. The computation results on an identical L are normalized by regarding the maximum output in the case of adopting the L as 100%. Added here is the remark that the shapes of the thermoelectric conversion sections may not necessarily be a square and the characteristic similar to Fig. 9 can be obtained even in the case of a rectangle or an oval.

As shown in Fig. 9, it is obvious that the output of a pn element has a maximum value in response to Ap/(Ap+An). It is found that, whatever the L value is, an output nearly close to a maximum value can be obtained as long as the range of $0.42 \leq$ Ap/(Ap+An) $\leq 0.6$ is satisfied.

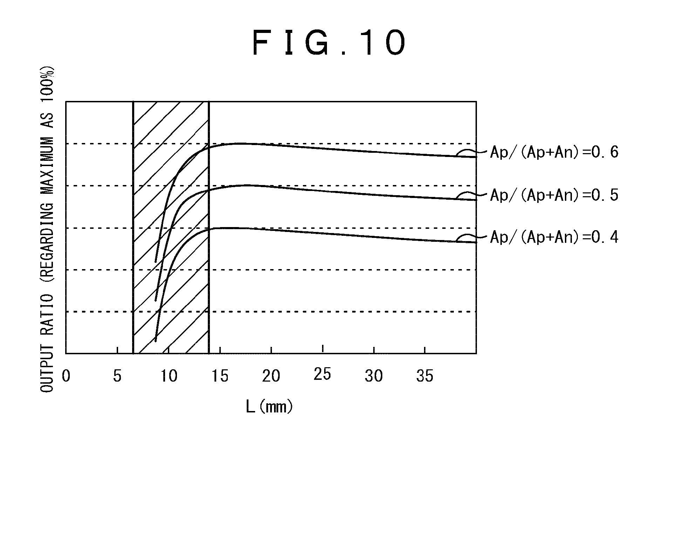

Fig. 10 is a graph showing the results of computing the change of an output obtained when the value of L is changed variously. The horizontal axis in Fig. 10 shows L. The vertical axis in Fig. 10 shows an electric power output per one pn element normalized by regarding the maximum output value of the pn element as 100%. The output characteristic of a pn element varies also by the value of Ap/(Ap+An) as shown in Fig. 9 and hence similar computations are carried out by using a plurality of same values. The computation results on an identical Ap/(Ap+An) are normalized respectively by regarding the maximum output in the case of adopting the Ap/(Ap+An) as 100%.

As shown in Fig. 10, it is obvious that an output not necessarily increases as L decreases, namely as the distance between an upper substrate 14 and a lower substrate 15 decreases and an optimum L value exists in response to a ratio of Ap and An. In any of the computation results however, when L increases to some extent, the output of a pn element tends to decrease as L increases. The reason is presumably that, if L increases, a heat quantity does not concentrate at a pn element and is discharged through another member. According to the computation results shown in Fig. 10, it is found that, whatever the value of Ap/(Ap+An) is, an output nearly close to a maximum value can be obtained as long as L is in the range of 6 mm $\leq$ L $\leq$14.5 mm.

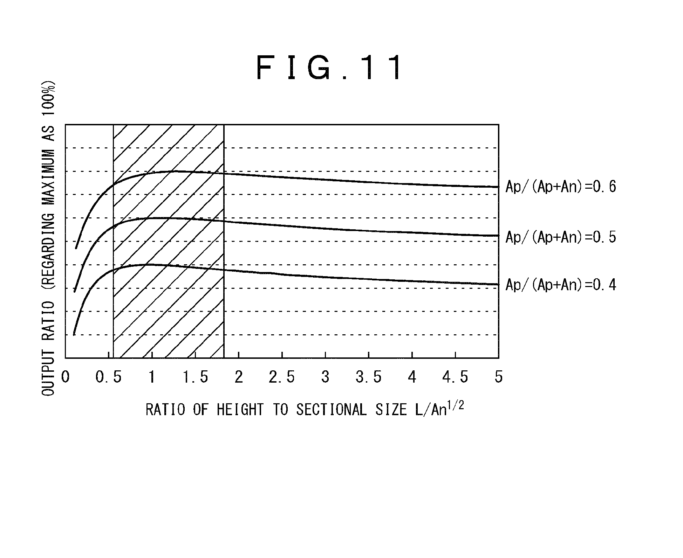

Fig. 11 is a graph showing the results of computing the change of an output obtained when the ratio between L and the sectional area of an n-type thermoelectric conversion section 12 is changed variously. Although the output of a pn element is influenced by L as shown in Fig. 10, it is estimated that the output also varies when the sectional area of the pn element varies even when L is the same. The output characteristic of a pn element therefore is computed by variously changing the ratio of L and An.

The horizontal axis in Fig. 11 shows the ratio of L to the square root $An^{1/2}$ of the sectional area of an n-type thermoelectric conversion section 12. The vertical axis in Fig. 11 shows an electric power output of one pn element normalized by regarding the maximum output value of the pn element as 100%. The output characteristic of a pn element varies also by the value of Ap/(Ap+An) as shown in Fig. 9 and hence similar computations are carried out by using a plurality of same values. The computation results on an identical Ap/(Ap+An) are normalized respectively by regarding the maximum output in the case of adopting the Ap/(Ap+An) as 100%.

As shown in Fig. 11, it is obvious that an optimum value of $L/An^{1/2}$ exists in response to the ratio of Ap and An. In any of the computation results, the output of a PN element tends to decrease gradually when the value of L to $An^{1/2}$ increases to some extent and the reason is estimated to be the same as that explained in Fig. 10. According to the computation results shown in Fig. 11, it is found that, whatever the value of Ap/(Ap+An) is, an output nearly close to a maximum value is obtained as long as the range of $0.6 \leq L/An^{1/2} \leq 1.8$ is satisfied.

Further, Fig. 11 can also be regarded as graphically showing the output variations in the cases of keeping Ap/(Ap+An) constant and changing $L/An^{1/2}$, namely the case of keeping Ap and An constant and increasing and decreasing L (pattern a) or the case of keeping L constant and integrally increasing and decreasing Ap and An (pattern b).

The (pattern a) can be interpreted as a maximum output is obtained in response to the value of L and hence it is obvious that the results nearly similar to Fig. 10 are obtained.

The (pattern b) can be interpreted as, if the value of L does not change, the output of a pn element increases and reaches a maximum value as the value of $L/An^{1/2}$ shifts from a smaller value toward a larger value, namely as both Ap and An shift from smaller values toward larger values and after that the output of the pn element decreases as the value of $L/An^{1/2}$ increases, namely as both Ap and An decrease.

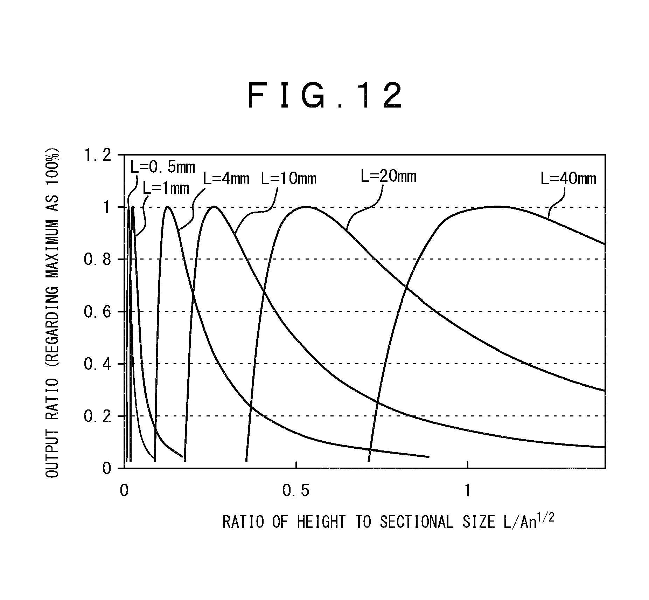

Fig. 12 is a graph showing the results of computing the change of an output obtained when the ratio between L and the sectional area of an n-type thermoelectric conversion section 12 is changed variously. The horizontal axis in Fig. 12 shows the ratio of L to the square root $An^{1/2}$ of the sectional area of the n-type thermoelectric conversion section 12. The vertical axis in Fig. 12 shows an electric power output of one pn element normalized by regarding the maximum output value of the pn element as 100%. The output characteristic of a pn element varies also in response to the value of L as shown in Fig. 10 and hence similar computations are carried out by using a plurality of same values. The computation results on the same L are normalized respectively by regarding the maximum output in the case of adopting the L as 100%.

As shown in Fig. 12, if the value of L does not change, the output of a pn element increases and reaches a maximum value as the value of $L/An^{1/2}$ shifts from a smaller value toward a larger value, namely as the value of $An^{1/2}$ shifts from a larger value toward a smaller value. After that, the output of the pn element decreases as the value of $L/An^{1/2}$ increases, namely as the value of $An^{1/2}$ decreases. This coincides with the trend of the (pattern b) explained in Fig. 11. In Fig. 12 however, attention should be paid to the fact that the premise that Ap/(Ap+An) is kept constant is not adopted.

Although the aforementioned tendency is the same whatever the value of L is, the optimum value of $L/An^{1/2}$ varies in response to the value of L and the value of $L/An^{1/2}$ allowing an output close to the maximum value to be obtained in any of the values of L has not been found.

Further, by the results shown in Fig. 12, it is obvious that, when the value of L is small, the range of $L/An^{1/2}$ allowing a large output to be obtained is narrow and the value of $L/An^{1/2}$ on that occasion is small, namely the value of An is large. In other words, it can be said that, when the value of L is small, the value of An should be large in comparison with L in order to obtain a large output. In contrast, it is obvious that, when the value of L is large, the range of $L/An^{1/2}$ allowing a large output to be obtained is wide and the value of $L/An^{1/2}$ on that occasion is large, namely the value of An is small. In other words, it can be said that the design allowance of An is large when the value of L is large to some extent.

Considering Figs. 11 and 12 in combination, it is obvious that it is only necessary to control the value of $L/An^{1/2}$ in the range of $0.6 \leq L/An^{1/2} \leq 1.8$ on the premise that the value of Ap/(Ap+An) is kept constant. Further, it is obvious that a larger L value is desirable from the viewpoint of the design allowance of Ap and An.

In Embodiment 2, on the premise of adopting a thermoelectric conversion material explained in Embodiment 1, the optimum dimensions of a thermoelectric conversion module 10 have heretofore been examined on the basis of various computation results. As a result, optimum values have been found on the dimensions of the sections. It is possible to optimize the efficiency of a thermoelectric conversion module 10 by adopting a thermoelectric conversion material explained in Embodiment 1 and a module structure explained in Embodiment 2 in combination.

(Embodiment 3)

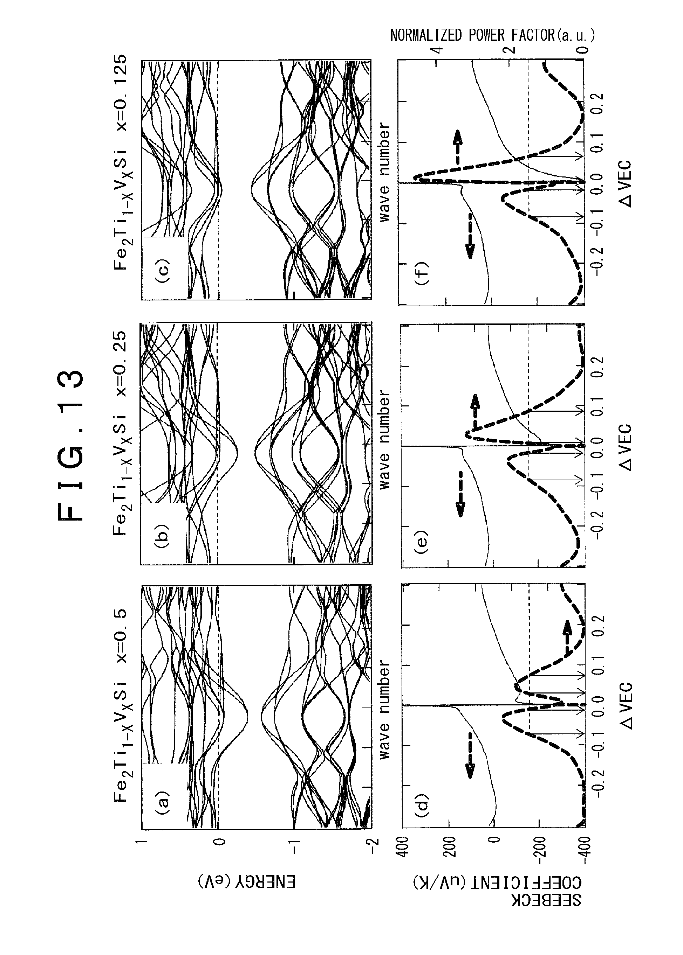

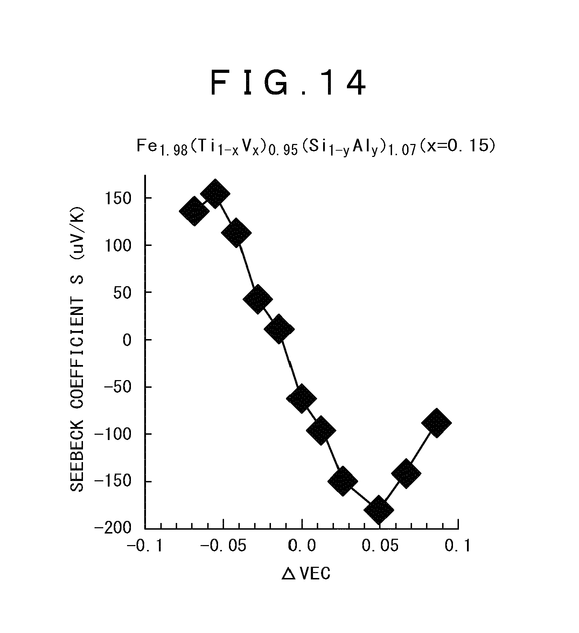

A thermoelectric conversion material according to Embodiment 3 of the present invention is explained in reference to Figs. 13 and 14. Here, items described in Embodiments 1 and 2 but not described in the present embodiment are applied also to the present embodiment unless the circumstances are exceptional.

As stated earlier, in the case of a thermoelectric conversion material of a Heusler alloy system, when a composition is modulated so as to adjust a VEC (total valence electron number per unit lattice), the carrier concentration of the thermoelectric conversion material is modulated and hence the thermoelectric conversion characteristic can be controlled. The case where a band structure is not changed by VEC adjustment and only a carrier concentration can be modulated however is limited only in the range where a VEC adjustment quantity is small. Consequently, a composition design taking a band structure into consideration is required in order to obtain an optimum value of a thermoelectric conversion characteristic in the range where a VEC adjustment quantity is large. In a Heusler alloy $Fe_{2+\sigma}$ $(Ti_{1-x}M_x)_{1+y}(Si_{1-w}N_w)_{1+z}$, particularly in the case of M = V and N = Al, a composition design taking the change of a band structure into consideration is carried out by using the first principle computation and an optimum value in the composition range is obtained. Since it is assumed that a band structure varies largely by M atom replacement but the band structure changes slightly by N atom replacement, numerical computation is carried out only on M replacement. The reason why a band structure varies by M atom replacement is that the main factor to decide the band structure of the alloy is estimated to be the bond of an Fe atom and a Ti atom.

(A) to (c) of Fig. 13 show the band structures of $Fe_{2+\sigma}$ $(T1_{1-x}M_x)_{1+y}(Si_{1-w}N_w)_{1+z}$ in the cases of $(\sigma, y, z) = (0, 0, 0)$ and the values of x (x =0.125, 0.25, and 0.5) obtained by the first principle computation. Further, (d) to (f) of Fig. 13 show the $\Delta$VEC dependencies of Seebeck coefficients and the $\Delta$VEC dependencies of normalized power factors in the cases of the values of x. A normalized power factor is normalized by regarding already existing $Fe_2TiSi$ as 1. From (a) to (c) of Fig. 13, it is obvious that a band gap shifts to the low energy side in response to the increase of x. In this way, since a band structure varies conspicuously in response to the increase of x, an appropriate $\Delta$VEC varies in response to the value of x. An appropriate $\Delta$VEC is decided in reference to (d) to (f) of Fig. 13.

From (d) to (f) of Fig. 13, it is obvious that, when a $\Delta$VEC is negative, the Seebeck coefficient is positive and namely the material comes to be a p-type thermoelectric conversion material and, when a $\Delta$VEC is positive, the Seebeck coefficient is negative and namely the material comes to be an n-type thermoelectric conversion material. Consequently, as shown in Fig. 13, a normalized power factor has a maximum value in each of the range of a positive $\Delta$VEC and the range of a negative $\Delta$VEC. It can be said that the maximum values of the normalized power factors and the vicinities thereof are high thermoelectric conversion characteristic regions. By setting a $\Delta$VEC so as to be $|\Delta VEC| \leq 0.2$, a thermoelectric conversion material including the maximum value of a normalized power factor can be obtained. In particular, a range where a normalized power factor is not less than 1.5 that is sufficiently larger than that of already existing $Fe_2TiSi$ is desirable and such a $\Delta$VEC is in the range of $0.001 \leq |\Delta VEC| \leq 0.09$.

More concretely, a $\Delta$VEC is in the range of $-0.09 \leq \Delta VEC(\sigma, w, x, y, z) \leq -0.01$ or $0.001 \leq \Delta VEC(\sigma, w, x, y, z) \leq 0.09$. Here, the range where x and w exceed 0.5 comes to be a composition largely deviating from $Fe_2TiSi$ and hence is excluded.

Through the above discussion, in a thermoelectric conversion material of $Fe_{2+\sigma}(Ti_{1-x}M_x)_{1+y}(Si_{1-w}N_w)_{1+z}$, it is desirable that the thermoelectric conversion material has x and w allowing $|\Delta VEC| \leq 0.2$ to be satisfied under the conditions of

```
VEC = [8(2+σ)+{4(1-x)+(valence electron number of M)x}(1+y)+{4(1-w)+(valence electron number of N)w}(1+z)]/4,
```

and

$\sigma$ = {(at% of Fe in the above region)-50}/25,

y = {(at% of Ti in the above region)-25}/25, and

z = {(at% of Si in the above region)-25}/25, and

when the variation of a VEC is defined as $\Delta$VEC, $\Delta$VEC = VEC- (VEC center value of each mother alloy composition).

The $\Delta$VEC is preferably in the range of $0.001 \leq |\Delta EC| \leq 0.09$.

Each of the elements M and N can be at least any one of Nb, V, Al, Ta, Cr, Mo, W, Hf, Ge, Ga, In, P, B, Bi, and Zr and further on this occasion, when a VEC $(\sigma, w, x, y, z)$ and a $\Delta$VEC are defined by a valence electron concentration VEC $(\sigma, w, x, y, z) = \{8*(2+\sigma)+(4*(1-x)+Z(M)*x)*(1+y)+(4*(1-w)+Z(N)*w)*(1+z)\}/4$ (Z(M), Z(N) = valence electron number of the outermost shell in an atom of the element M or N), (VEC center value) = VEC $(\sigma, 0, 0, y, z) = \{8*(2+\sigma)+(4*(1+y)+4*(1+z)\}/4$, and $\Delta$VEC $(\sigma, w, x, y, z) = $ VEC $(\sigma, w, x, y, z)$-(VEC center value), it is desirable that: the elements M and N are V and Al respectively; and $\Delta$VEC $(\sigma, w, x, y, z) = \{x*(1+y)-w*(1+z)\}/4$, $-0.09 \leq \Delta$VEC $(\sigma, w, x, y, z)$ $\leq -0.01$, $0.001 \leq \Delta$VEC $(\sigma, w, x, y, z) \leq 0.09$, $0 \leq x < 0.5$, $0 \leq w < 0.5$, and $\sigma + x + w = 0$ (here, x = w = 0 is excluded) are satisfied. More appropriate ranges of $\Delta$VEC are $-0.09 \leq \Delta$VEC $(\sigma, w, x, y, z) \leq -0.01$ and $0.001 \leq \Delta$VEC $(\sigma, w, x, y, z) \leq 0.09$.

Here, multiplication is expressed by "no mark", "x", "*", etc. in the present specification but they are the same.

As stated above, a thermoelectric conversion material can be manufactured in accordance with a design guide by using a sintering method with a hot press. The weight of element powder to be a material is adjusted so that the element composition ratio of an alloy may be as designed and then the powder is fed into a carbon die and sintered.

In the case of manufacturing an $Fe_2TiVSi$ system alloy for example, the powder of the elements Fe, Ti, V, and Si is weighed so that the element composition ratio may satisfy the above composition formula and is fed into a carbon die. For example, it is possible to prepare a material of $Fe_{2+\sigma}(Ti_{1-x}M_x)_{1+y}(Si_{1-w}N_w)_{1+z}$ so as to be $Fe_{1.98}(Ti_{1-x}V_x)_{0.95}(Si_{1-y}Al_y)_{1.07}$ (X =0.15, $0 \leq y \leq 0.23$) Successively, the material is reacted and sintered at 800°C for 5,000 seconds for example. Further, it is also possible to apply heating treatment at 600°C for 2 days for example in order to improve the regularity of the crystal structure of a sintered body finished by the reaction and sintering. In the present composition, by mixing V as an additive material, it is attempted to improve the performance of a thermoelectric conversion material and stabilize the crystal structure. The pellets thus manufactured are processed into the aforementioned sizes and the thermoelectric conversion material is obtained.

In order to know the full picture of an appropriate composition range, materials of some compositions are synthesized on the basis of the above design guide. The relationship between a Seebeck coefficient and a $\Delta$VEC in the alloys is shown in Fig. 14. As shown in Fig. 14, high performance is confirmed. The extreme value of a Seebeck coefficient exists at a position where a VEC value increases and decreases slightly from a VEC value where the polarity of the Seebeck coefficient reverses (not necessarily VEC =6 in the case of a non-stoichiometric composition) and hence the Seebeck coefficient is especially high in the case of a composition or an added element quantity allowing such a VEC to be obtained. In actual experiments, a high thermoelectric conversion characteristic is obtained by designing a composition in the range of $-0.09 \leq \Delta$VEC $(\sigma, w, x, y, z) \leq -0.01$ and $0.001 \leq \Delta$VEC $(\sigma, w, x, y, z) \leq 0.09$ from the center value of a VEC.

A thermoelectric conversion material according to the present invention is not necessarily manufactured by the method in the present embodiment and can be manufactured appropriately also by a casting method such as an arc melting method. Further, a thermoelectric conversion material can be manufactured appropriately also by a method of being alloyed by arc melting, being pulverized thereafter, and obtaining a sintered body by hot press or spark plasma sintering. Otherwise, a thermoelectric conversion material can be manufactured appropriately also by a method of manufacturing alloy powder by mechanical alloying when the alloy is manufactured and obtaining a sintered body by hot press or spark plasma sintering. Moreover, an intended alloy can be manufactured also by a thin piece obtained by rapidly cooling the material after it is melted. Moreover, a thermoelectric conversion material can be manufactured appropriately also by a method of powderizing a thin piece obtained by rapidly cooling the material after it is melted and obtaining a sintered body by hot press or spark plasma sintering. Otherwise, a method of obtaining powder by heating raw material powder adjusted to a given composition by thermal plasma and successively rapidly cooling the powder can be adopted appropriately. Then a thermoelectric conversion material can be manufactured appropriately also by a method of obtaining a sintered body by hot press or spark plasma sintering by using the powder obtained by the thermal plasma.

A thermoelectric conversion material explained in Embodiment 3 is applied to a thermoelectric conversion module according to Embodiment 1 and a less poisonous thermoelectric conversion module having a high thermoelectric conversion efficiency can be provided. Further, a thermoelectric conversion material explained in Embodiment 3 is applied to a module structure explained in Embodiment 2 and the efficiency of the thermoelectric conversion module can be optimized.

Here, the present invention is not limited to the aforementioned embodiments and includes various modified examples. For example, the aforementioned embodiments are explained in detail for better understanding of the present invention and the present invention is not necessarily limited to the embodiments having the explained whole configuration. Further, a part of the configuration of an embodiment can also be replaced with the configuration of another embodiment and the configuration of an embodiment can be added to the configuration of another embodiment. Furthermore, a part of the configuration of an embodiment can be added to, deleted from, or replaced with another configuration.

**Claims**

1. A thermoelectric conversion material wherein said thermoelectric conversion material is a full-Heusler alloy, is represented by the composition formula $Fe_{2+\sigma}Ti_{1+y}Si_{1+z}$, and has $\sigma$, y, and z allowing the material to fall within the region surrounded by (Fe, Ti, Si) = (50, 37, 13), (50, 14, 36), (45, 30, 25), (39.5, 25, 35.5), (54, 21, 25), and (55.5, 25, 19.5) {excluding (50, 25, 25)} by at% in an Fe-Ti-Si ternary alloy phase diagram.

2. The thermoelectric conversion material according to Claim 1, wherein said full-Heusler alloy represented by the composition formula $Fe_{2+\sigma}Ti_{1+y}Si_{1+z}$ has $\sigma$, y, and z allowing the material to fall within the region surrounded by (Fe, Ti, Si) = (39.5, 25, 35.5), (47.5, 27.5, 25), (50, 17, 33), (50, 35, 15), (52.8, 25, 22.2), and (52.2, 22.8, 25) {excluding (50, 25, 25)} by at% in an Fe-Ti-Si ternary alloy phase diagram.

3. The thermoelectric conversion material according to Claim 2, wherein the full-Heusler alloy represented by the composition formula $Fe_{2+\sigma}Ti_{1+y}Si_{1+z}$ has $\sigma$, y, and z allowing the material to fall within the region surrounded by (Fe, Ti, Si) = (41, 25, 34), (49.2, 25.8, 25), (50, 23, 27), (50, 32.6, 17.4), (51, 25, 24), and (51, 24, 25) {excluding (50, 25, 25)} by at% in an Fe-Ti-Si ternary alloy phase diagram.

4. The thermoelectric conversion material according to at least one of the Claims 1 to 3, wherein: said full-Heusler alloy represented by the composition formula $Fe_{2+\sigma}Ti_{1+y}Si_{1+z}$ is modulated from the stoichiometric composition by replacing Ti and Si with an element M and an element N respectively and is represented by the composition formula $Fe_{2+\sigma}(Ti_{1-x}M_x)_{1+y}(Si_{1-w}N_w)_{1+z}$; and the modulated full-Heusler alloy has x and w allowing $|\Delta VEC| \leq 0.2$ to be satisfied under the conditions of

```
VEC = [8(2+σ)+{4(1-x)+(valence electron number of M)x}(1+y)+{4(1-w)+(valence electron number of N)w}(1+z)]/4,
```

and

$\sigma$ = {(at% of Fe in the region)-50}/25,
y = {(at% of Ti in the region)-25}/25, and
z = {(at% of Si in the region)-25}/25, and
when the variation of a VEC is defined as $\Delta VEC$, $\Delta VEC$ = VEC-(VEC center value of each mother alloy composition).

5. The thermoelectric conversion material according to Claim 4, wherein each of the element M and the element N is at least any one of Nb, V, Al, Ta, Cr, Mo, W, Hf, Ge, Ga, In, P, B, Bi, and Zr.

6. The thermoelectric conversion material according to Claim 5, wherein the element M is V and $|x| \leq 0.25$ is satisfied.

7. A thermoelectric conversion material wherein the thermoelectric conversion material is a full-Heusler alloy, is represented by the composition formula $Fe_{2+\sigma}Ti_{1+y}Sn_{1+z}$, and has $\sigma$, y, and z allowing the material to fall within the region surrounded by (Fe, Ti, Sn) = (50, 37, 13), (50, 14, 36), (45, 30, 25), (39.5, 25, 35.5), (54, 21, 25), and (55.5, 25, 19.5) {excluding (50, 25, 25)} by at% in an Fe-Ti-Sn ternary alloy phase diagram.

8. The thermoelectric conversion material according to Claim 7, wherein SiSn is used in place of the Sn.

9. A thermoelectric conversion module (10) having:

**EP 2 886 669 A1**

a p-type thermoelectric conversion section (11) and an n-type thermoelectric conversion section (12), those including a thermoelectric conversion material according to Claim 7;

an electrode (13) to connect the p-type thermoelectric conversion section and the n-type thermoelectric conversion section in series; and

an upper substrate (14) and a lower substrate (15) installed in the manner of interposing the p-type thermoelectric conversion section (11) and the n-type thermoelectric conversion section (12), those being connected in series.

10. A thermoelectric conversion module having a p-type thermoelectric conversion section (11) and an n-type thermoelectric conversion section (12), wherein each of the p-type thermoelectric conversion section and the n-type thermoelectric conversion section is a full-Heusler alloy, is represented by the composition formula $Fe_{2+\sigma}Ti_{1+y}Si_{1+z}$, and has $\sigma$, y, and z allowing the material to fall within the region surrounded by (Fe, Ti, Si) = (50, 37, 13), (50, 14, 36), (45, 30, 25), (39.5, 25, 35.5), (54, 21, 25), and (55.5, 25, 19.5) {excluding (50, 25, 25)} by at% in an Fe-Ti-Si ternary alloy phase diagram.

11. The thermoelectric conversion module according to Claim 10, wherein: the full-Heusler alloy represented by the composition formula $Fe_{2+\sigma}Ti_{1+y}Si_{1+z}$ is modulated from the stoichiometric composition by replacing Ti and Si with an element M and an element N respectively and is represented by the composition formula $Fe_{2+\sigma}(Ti_{1-x}M_x)_{1+y}(Si_{1-w}N_w)_{1+z}$; and the modulated full-Heusler alloy has x and w allowing |$\Delta$VEC| <0.2 to be satisfied under the conditions of

$$\text{VEC} = [8(2+\sigma)+\{4(1-x)+(\text{valence electron number of}$$

$$\text{M})x\}(1+y)+\{4(1-w)+(\text{valence electron number of N})w\}(1+z)]/4,$$

and

$\sigma$ = {(at% of Fe in the region)-50}/25,
y = {(at% of Ti in the region)-25}/25, and
z = {(at% of Si in the region)-25}/25, and
when the variation of a VEC is defined as $\Delta$VEC, $\Delta$VEC = VEC-(VEC center value of each mother alloy composition).

12. The thermoelectric conversion module (10) according to Claim 10, wherein the thermoelectric conversion module has a substrate over which the p-type thermoelectric conversion section (11) and the n-type thermoelectric conversion section (12) are installed, and is configured so that the ratio of the sectional area of the p-type thermoelectric conversion section to the sum of the sectional area of the p-type thermoelectric conversion section and the sectional area of the n-type thermoelectric conversion section on a plane perpendicular to the normal line of the substrate may fall in the range of 0.42 to 0.6.

13. The thermoelectric conversion module (10) according to Claim 10, wherein the thermoelectric conversion module has a substrate over which the p-type thermoelectric conversion section (11) and the n-type thermoelectric conversion section (12) are installed, and is configured so that the length of the p-type thermoelectric conversion section in the normal line direction of the substrate and the length of the n-type thermoelectric conversion section in the normal line direction may fall in the range of 6 mm to 14.5 mm.

14. The thermoelectric conversion module (10) according to Claim 10, wherein the thermoelectric conversion module has a substrate over which the p-type thermoelectric conversion section (11) and the n-type thermoelectric conversion section (12) are installed, and is configured so that the ratio of the length of the p-type thermoelectric conversion section in the normal line direction of the substrate or the length of the n-type thermoelectric conversion section in the normal line direction to the square root of the sectional area of the n-type thermoelectric conversion section on the plane perpendicular to the normal line of the substrate may fall in the range of 0.6 to 1.8.

15. The thermoelectric conversion module (10) according to Claim 10, wherein:

the p-type thermoelectric conversion section (11) and the n-type thermoelectric conversion section (12) are electrically connected in series through an electrode (13); and

15

the electrode is formed by using Cu, Au, or Ta as the material.

16. The thermoelectric conversion material according to Claim 5, wherein, when a valence electron number VEC ($\sigma$, w, x, y, z) = {8*(2+$\sigma$)+(4*(1-x)+Z(M)*x)*(1+y)+(4*(1-w)+Z(N)*w)*(1+z)}/4 (Z(M), Z(N) = valence electron number of the outermost shell in an atom of the element M or N), (VEC center value) = VEC ($\sigma$, 0, 0, y, z) = {8*(2+$\sigma$)+(4*(1+y)+4*(1+z)}/4, and $\Delta$VEC ($\sigma$, w, x, y, z) = VEC ($\sigma$, w, x, y, z)-(VEC center value) are defined:

the elements M and N are V and Al respectively; and
$\Delta$VEC ($\sigma$, w, x, y, z) = {x*(1+y)-w*(1+z)}/4, -0.09$\leq \Delta$VEC ($\sigma$, w, x, y, z) $\leq$-0.01, 0.001$\leq \Delta$VEC ($\sigma$, w, x, y, z) $\leq$0.09, 0$\leq$ x < 0.5, 0$\leq$ w < 0.5, and $\sigma$+x+w =0 (here, x = w =0 is excluded) are satisfied.

17. The thermoelectric conversion material according to Claim 16, wherein the thermoelectric conversion material is a p-type.

18. The thermoelectric conversion material according to Claim 16, wherein the thermoelectric conversion material is an n-type.

19. The thermoelectric conversion material according to Claim 1, wherein, in the composition formula, y =0 and $\sigma$ = -z are satisfied and $\sigma$ is in the range of -0.36$\leq \sigma \leq$-0.04.

20. The thermoelectric conversion material according to Claim 1, wherein, in the composition formula, $\sigma$=0 and y = -z are satisfied and y is in the range of 0.04$\leq$ y $\leq$0.32.

21. The thermoelectric conversion material according to Claim 4, wherein the |$\Delta$VEC| is in the range of 0.001$\leq$ |$\Delta$VEC| $\leq$0.09.

22. The thermoelectric conversion module according to Claim 11, wherein the |$\Delta$VEC| is in the range of 0.001$\leq$ |$\Delta$VEC| $\leq$0.09.

# F I G . 1 A

# F I G . 1 B

# FIG.2A

# FIG.2B

# F I G . 3 A

# F I G . 3 B

# F I G . 3 C

# F I G . 3 D

# F I G . 3 E

# FIG.3F

# FIG.3G

# F I G . 4 A

# F I G . 4 B

# FIG.4C

# FIG.4D

EP 2 886 669 A1

# FIG.4E

# FIG.4F

# FIG.5

# F I G . 6

# F I G . 7

# FIG.8A

# FIG.8B

# FIG.8C

# FIG.9

L=0.5mm
L=1mm
L=4mm
L=10mm
L=20mm
L=40mm

OUTPUT RATIO (REGARDING MAXIMUM AS 100%)

0  0.1  0.2  0.3  0.4  0.5  0.6  0.7  0.8  0.9  1

AREA RATIO OF P-TYPE THERMOELECTRIC CONVERSION MATERIAL
TO GROSS SECTIONAL AREA Ap/(Ap+An)

# FIG.10

# FIG.11

OUTPUT RATIO (REGARDING MAXIMUM AS 100%)

Ap/(Ap+An)=0.6

Ap/(Ap+An)=0.5

Ap/(Ap+An)=0.4

0   0.5   1   1.5   2   2.5   3   3.5   4   4.5   5

RATIO OF HEIGHT TO SECTIONAL SIZE $L/An^{1/2}$

# FIG.12

OUTPUT RATIO (REGARDING MAXIMUM AS 100%)

L=0.5mm
L=1mm
L=4mm
L=10mm
L=20mm
L=40mm

RATIO OF HEIGHT TO SECTIONAL SIZE $L/An^{1/2}$

# FIG.13

$Fe_2Ti_{1-X}V_XSi$  x=0.5          $Fe_2Ti_{1-X}V_XSi$  x=0.25          $Fe_2Ti_{1-X}V_XSi$  x=0.125

EP 2 886 669 A1

# FIG.14

$Fe_{1.98}(Ti_{1-x}V_x)_{0.95}(Si_{1-y}Al_y)_{1.07}(x=0.15)$

Europäisches
Patentamt

European
Patent Office

Office européen
des brevets

## EUROPEAN SEARCH REPORT

**Application Number**

EP 14 19 3879

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/014798 A1 (NISHIDE AKINORI [JP] ET AL) 17 January 2013 (2013-01-17) * paragraph [0035] - paragraph [0045]; figures 1-6 * | 1-22 | INV. C22C1/04 C22C38/00 H01L35/20 |
| A | SHIN YABUUCHI, MASAKUNI OKAMOTO, AKINORI NISHIDE, YOSUKE KUROSAKI, AND JUN HAYAKAWA: "Large Seebeck Coefficients of Fe2TiSn and Fe2TiSi: First-Principles Study", APPLIED PHYSICS EXPRESS, vol. 6, no. 2, 025504, 30 January 2013 (2013-01-30), pages 1-3, XP002738883, * the whole document * | 1-22 | |
| A | V. RAGHAVAN: "Fe-Si-Ti (Iron-Silicon-Titanium)", JOURNAL OF PHASE EQUILIBRIA AND DIFFUSION, vol. 30, no. 4, 2009, pages 393-396, XP002738884, * the whole document * | 1-22 | TECHNICAL FIELDS SEARCHED (IPC) C22C H01L |

The present search report has been drawn up for all claims

| Place of search | Date of completion of the search | Examiner |
|---|---|---|
| Munich | 23 April 2015 | Liu, Yonghe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 19 3879

This annex lists the patent family members relating to the patent documents cited in the above-mentioned European search report.
The members are as contained in the European Patent Office EDP file on
The European Patent Office is in no way liable for these particulars which are merely given for the purpose of information.

23-04-2015

| Patent document cited in search report | Publication date | Patent family member(s) | | Publication date |
|---|---|---|---|---|
| US 2013014798 A1 | 17-01-2013 | JP | 5663422 B2 | 04-02-2015 |
| | | JP | 2013021089 A | 31-01-2013 |
| | | US | 2013014798 A1 | 17-01-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2003019681 A
- WO 2013093967 A